# EUROPEAN PATENT SPECIFICATION

(11) **EP 2 098 911 B1**
(45) Date of publication and mention of the grant of the patent: **11.09.2013**
(21) Application number: 09154573.1
(22) Date of filing: 06.03.2009
(51) Int. Cl.: G03F 7/42

(54) **Stripper for dry film removal and method using the same**
Abbeizmittel zur Trockenfilmentfernung und Verfahren zu dessen Anwendung
Dissolvant pour retrait de films secs et procédé l'utilisant

(30) Priority: 07.03.2008 US 34592 P; 27.02.2009 US 394183
(43) Date of publication of application: 09.09.2009
(73) Proprietor: Air Products and Chemicals, Inc., Allentown, PA 18195-1501 (US)
(72) Inventor: Liu, Wen Dar, 302 Chupei City (TW); Lee, Yi-Chia, 251 Danshu (TW); Liao, Archie, 104 Taipei (TW); Rao, Madhukar Bhaskara, Fogelsville, PA 18051 (US); Egbe, Matthew I., West Norriton, PA 19403 (US); Sheu, Chimin, 300 Taipei (TW); Legenza, Michael Walter, 02019 Bellingham (TW)
(74) Representative: Muir, Benjamin M. J.

(56) References cited:
- EP-A1- 1 736 534
- EP-A1- 1 808 480
- WO-A1-03/091376
- US-A1- 2003 181 344
- US-A1- 2004 137 379
- US-A1- 2005 263 743

## Description

### BACKGROUND OF THE INVENTION

In the manufacture of semiconductor circuits on wafers, the wafers are periodically coated with photoresist to fabricate the various layers of circuitry, electrical devices and vias and interconnects. After photoresist is developed and used, etching and ashing are performed resulting in residues that must be removed before further processing. Strippers have been utilized to remove unwanted photoresist and the residues of etching and ashing. The photoresist, etch residue or ash residue is difficult to selectively remove without damaging the desired circuit structures. The stripper must be compatible with dielectric and metal conductive materials. The corrosion rate of either of these differing types of materials must be within acceptable levels.

Commercially available strippers for the removal of thick dry film (films usually ranging from 70 to 120 micrometer (micron (µm)) in thickness) comprise a mixture of dimethylsulfoxide (DMSO) and tetramethylammonium hydroxide (TMAH). These strippers usually operate at elevated temp (>90°C) and suffer from short bath-life issues. Strippers in this field are described in US 2005/0263743, US 2006/0094613 and US 2006/0115970.

EP1736534 discloses a composition for removing residues from a substrate, which composition comprises one of the following cationic salts as the main component: guanidinium cation, formamidinium cation, or acetamidinium cation.

WO03/091376 discloses a cleaning composition for aluminium, copper and dielectric surfaces, which composition comprises oxalic acid as its main component.

US2003/0181344 discloses a photoresist stripping composition containing at least one oxymethylamine compound having an alkoxymethylamine structure or an alkoxymethylamine structure substituted by an ether linkage containing substituent as its main component.

US2005/0263743 discloses components and processing for removing polymers, post etch residues and post oxygen ashing residues. Claim 1 discloses a composition comprising a mixture of an organic ammonium compound, an oxoamonnium compound and water. Examples of suitable organic ammonium compounds include tetramethyl ammonium hydroxide, and examples of suitable oxoammonium compounds include hydroxylamine. Components such as organic solvents and chelating agents/corrosion inhibitors may optionally be present, or alternatively the composition may be substantially free of solvents and substantially free of chelators and corrosion inhibitors. However, the document does not disclose a composition consisting of water, hydroxylamine, a base, an organic solvent, a metal corrosion inhibiting agent and a bath life extending agent according to the present invention.

### BRIEF SUMMARY OF THE INVENTION

According to one aspect, the present invention is a photoresist stripper formulation for removing photoresist, etch residue or ash residue from a semiconductor device surface, said photoresist stripper formulation consisting of hydroxylamine, water, a solvent, a base, a metal corrosion inhibitor, and a bath life extending agent.

The solvent is selected from dimethylsulfoxide, N-methylpyrrolidine, dimethylacetamide, dipropylene glycol monomethyl ether, monoethanolamine and mixtures thereof. The base is selected from choline hydroxide, monoethanolamine, tetramethylammonium hydroxide, aminoethylethanolamine and mixtures thereof. Thus, where monoethanolamine is present in the formulation it may be present as both a solvent and a base, and an additional solvent or base need not be present (though additional solvents or bases may be used, if desired).

The metal corrosion inhibitor is selected from catechol, gallic acid, lactic acid, benzotriazole and mixtures thereof.

The bath life extending agent is selected from glycerine, propylene glycol and mixtures thereof. In a some embodiments, hydroxylamine may be present in an amount of 2.5 to 5% by weight, water may be present in an amount of 20 to 40% by weight, the solvent may be present in an amount of 40 to 70% by weight, the base may be present in an amount of 5 to 7.5% by weight, the metal corrosion inhibitor may be present in an amount of 0.25 to 1 % by weight, and the bath life extending agent may be present in an amount of 2 to 10% by weight (all weight % by total weight of the formulation).

In one embodiment, the photoresist stripper formulation comprises, 5 to 10 wt % hydroxylamine (50% aqueous solution), 5 to10 wt % water, 40 to 70 wt % dimethylsulfoxide, 20 to 30 wt % tetramethylammonium hydroxide (25% aqueous solution), 0.25 to1.0 wt % catechol, and 2 to10 wt % glycerine.

According to another aspect, the present invention is a method of stripping photoresist, etch residue or ash residue, using a photoresist stripper formulation as described above.

### BRIEF DESCRIPTION OF SEVERAL VIEWS OF THE DRAWINGS

Figure 1 shows Scanning Electron Microscopy (SEM) images of a discretely patterned film before and after cleaning using the photoresist stripper formulation described in Table 2.
Figure 2 shows Scanning Electron Microscopy (SEM) images of cross-sections of a copper film on a substrate, showing the level of copper loss over a 75 hours test period during which the film was exposed to the photoresist stripper formulation described in Table 2.
Figure 3 shows Scanning Electron Microscopy (SEM) images of discretely patterned films cleaned at various time intervals using the photoresist stripper formulation described in Table 2, demonstrating active bath life over the 75 hours test period.

### DETAILED DESCRIPTION OF THE INVENTION

Photoresist stripper formulations have been used in this field, but currently these formulations suffer from high copper conductor etch rates, shorter photoresist stripper active bath-life, and undesirable operating temperatures.

A new photoresist stripper was developed for dry film removal in accordance with the present invention. A series of tests were performed and several key components were found to be strongly related to dry film removal and copper protection. Compared with commercial strippers used for dry film cleaning, this strippers of the present invention can be used under milder conditions (preferably 60°C for 30 minutes) and have comparable cleaning performance and copper conductive line etch rate. Furthermore, the active bath-life is significantly improved in the present invention.

The formulations according to the present invention have some distinct features:
1. The strippers of the present invention show good cleaning of dry film at 60°C for 30 minutes without agitation;
2. Cross-sections of substrates processed with the present strippers, viewed using Scanning Electron Microscopy( SEM), show that copper loss is less than 10% over a 75 hours test period;
3. The bath-life of the strippers of the present invention is greater than 75 hours at 60°C.

### Working Examples

In the working examples, the following abbreviations have been used:
TMAH= tetramethylammonium hydroxide;
DMSO= dimethylsulfoxide;
HA = hydroxylamine;
NMP = N-methylpyrrrolidine;
DMAC = dimethylacetamide;
DPM = dipropylene glycol monomethyl ether;
MEA = monoethanolamine;
AEEA = aminoethylethanolamine;
DIW = deionized water;
BZT = benzotriazole.

### Example 1

A present photoresist stripper formulation was prepared in accordance with Table 1, below. In this table, TMAH (25% solution) refers to an aqueous solution of TMAH comprising 25 wt. % TMAH and 75 wt. % water. Similarly, HA (50% solution) refers to an aqueous solution of HA comprising 50 wt. % HA and 50 wt. % water.

**Table 1**

| Addition Order | Raw Material-Pilot Plant | Wt. Pct | 500g scale | Max. temp (°C) |
|---|---|---|---|---|
| 1 | Water | 5.72% | 28.6 | 24 |
| 2 | TMAH (25% solution) | 22.87% | 114.35 | 24 |
| 3 | DMSO | 57.18% | 285.9 | 37 |
| 4 | HA (50% solution) | 8.26% | 41.3 | 39 |
| 5 | Glycerine | 5.40% | 27 | 37 |
| 6 | Catechol | 0.57% | 2.85 | 37 |

The resulting photoresist stripper formulation according to a preferred embodiment of the present invention has a compositional makeup as set forth in Table 2. Preferred ranges of compositional content for certain other preferred embodiments of the invention are also shown.

**Table 2**

| Component | Preferred Embodiment (wt% based on total weight of the formulation) | Range (wt% based on total weight of the formulation) |
|---|---|---|
| DMSO | 57.18 | 51 to 63 |
| TMAH(25%) | 22.87 | 20 to 26 |
| HA(50%) | 8.26 | 7 to 9.5 |
| DIW | 5.72 | 5 to 6.5 |
| Glycerine | 5.40 | 4.5 to 6 |
| Catechol | 0.57 | 0.50 to 0.60 |
| Total | 100.00 | |

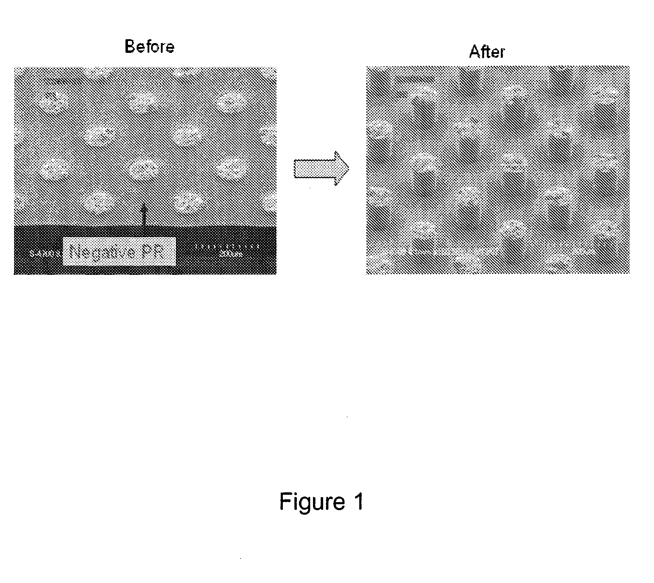

The preferred embodiment of Table 2 was tested on a discretely patterned film on a substrate (a dry film) under process conditions of 60°C for 30 minutes. The excellent cleaning performance was clearly shown by the SEM scanning images shown in Figure 1.

In other embodiments of the invention the composition of the photoresist formulation may be varied, for example by substituting one or more of the components listed in Table 2 with the analogs listed in Table 3, below.

**Table 3**

| Component | Analogs |
|---|---|
| DMSO | NMP, DMAC, DPM, MEA |
| TMAH | Choline hydroxide, MEA, AEEA |
| HA | |
| DIW | |
| Glycerine | propylene glycol |
| Catechol | Gallic acid, Lactic acid, BZT |

### Example 2

The photoresist stripper formulation according to the preferred embodiment set forth in Table 2 was tested on a copper film on a substrate under process conditions comprising a temperature of 60°C and for the time intervals shown in Table 4, below.

**Table 4**

| Time | Copper Etch in Angstroms (1 Angstrom = 0.1 nm) |
|---|---|
| Control | 4830 |
| 0 Hours | 4440 |
| 20 Hours | 4617 |
| 27 Hours | 4611 |
| 45 Hours | 4782 |
| 75 Hours | 4440 |

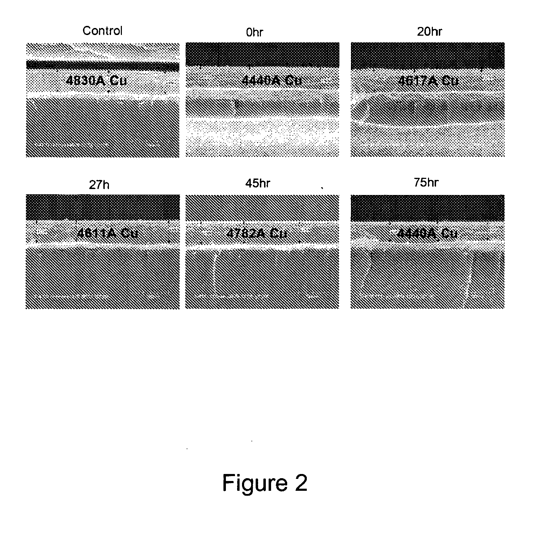

The Cu loss was checked by Scanning Electron Microscopy (SEM). The SEM data is shown in Figure 2 and Table 4.

This data demonstrates that this embodiment of the stripper formulation of the present invention shows acceptable levels of copper etch over a wide range of time of exposure. The copper loss was less than 10% within the 75 hours test period.

### Example 3

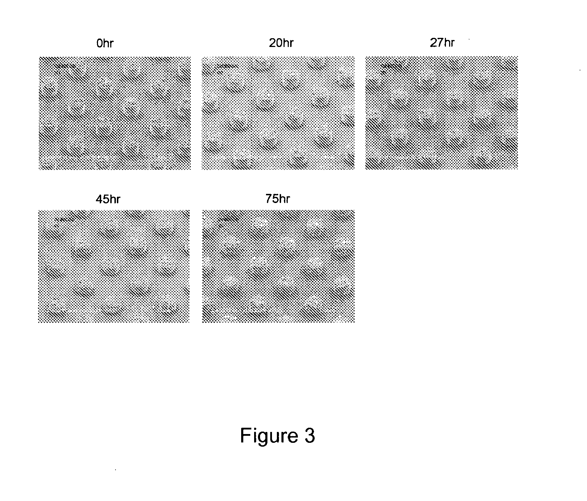

The photoresist stripper formulation according to the preferred embodiment set forth in Table 2 was tested on a discretely patterned film on a substrate under process conditions comprising a temperature of 60°C and for the time intervals of 20 hours, 27 Hours, 45 Hours, and 75 Hours. The SEM images are shown in Figure 3. Effective bath life, based upon removal of film from patterned geometry, was determined visually from the images. The results are shown in Table 5.

**Table 5**

| Time | High Definition* | Medium Definition* | Low Definition* |
|---|---|---|---|
| 0 Hours | X | | |
| 20 Hours | X | | |
| 27 Hours | X | | |
| 45 Hours | X | | |
| 75 Hours | X | | |

| | | | |
|---|---|---|---|
| "Definition" = preservation of a desired geometry on a wafer while removal by the stripper of undesired surrounding materials, with sharp angles and shapes retained. | | | |

The results in Table 5 show that a stripper of the present invention, as exemplified by the preferred embodiment set forth in Table 2, has effective stripping ability over the span of 75 hours.

The above working examples shown that the new photoresist stripper formulations according to the present invention are effective for dry film removal. Several key components were found to be strongly related to dry film removal and copper protection. Hydroxylamine in the stripping formulation reacts with dry film and increases the solubility, allowing significantly reduced process temperatures, such as down to 60°C. Glycerine slows down DIW evaporizing speed and prolongs the bath-life. Catechol prevents copper corrosion.

The stripping formulations have been demonstrated as having a stripping effect on a discretely patterned film on a substrate (a dry film) in the working examples. However, it should be understood that the stripping formulations can be used to remove photoresist and residues left from etching and ashing processes from any semiconductor device surface.

While specific embodiments have been described in detail, those with ordinary skill in the art will appreciate that various modifications and alternatives to these embodiments could be developed in light of the overall teaching of the disclosure. Accordingly, the particular embodiments disclosed are meant to be illustrative only and not limiting to the scope of the appended claims.

## Claims

1. A photoresist stripper formulation for removing photoresist, etch residue or ash residue from a semiconductor device surface, the photoresist stripper formulation consisting of:
hydroxylamine;
water;
a solvent selected from dimethylsulfoxide, N-methylpyrrolidine, dimethylacetamide, dipropylene glycol monomethyl ether, monoethanolamine and mixtures thereof;
a base selected from choline hydroxide, monoethanolamine, tetramethylammonium hydroxide, aminoethylethanolamine and mixtures thereof;
a metal corrosion inhibitor selected from catechol, gallic acid, lactic acid, benzotriazole and mixtures thereof; and
a bath life extending agent selected from glycerine, propylene glycol and mixtures thereof.

2. The formulation of Claim 1, wherein the photoresist stripper formulation consists of:
hydroxylamine;
water;
dimethylsulfoxide;
tetramethylammonium hydroxide;
catechol; and,
glycerine.

3. The formulation of Claim 2, wherein the photoresist stripper formulation consists of:
2.5 to 5 wt % hydroxylamine;
20 to 40 wt % water;
40 to 70 wt % dimethylsulfoxide;
5 to 7.5 wt % tetramethylammonium hydroxide;
0.25 to1.0 wt % catechol; and
2 to 10 wt% glycerine.

4. The formulation of Claim 3, wherein the photoresist stripper formulation consists of:
4.13 wt % hydroxylamine;
27 wt % water;
57.18 wt% dimethylsulfoxide;
5.72 wt% tetramethylammonium hydroxide;
0.57 wt % catechol; and
5.4 wt % glycerine.

5. A method for removing photoresist, etch residue or ash residue from a semiconductor device surface, the method comprising contacting the photoresist, etch residue or ash residue with a photoresist stripper formulation consisting of:
hydroxylamine;
water;
a solvent selected from dimethylsulfoxide, N-methylpyrrolidine, dimethylacetamide, dipropylene glycol monomethyl ether, monoethanolamine and mixtures thereof;
a base selected from choline hydroxide, monoethanolamine, tetramethylammonium hydroxide, aminoethylethanolamine and mixtures thereof;
a metal corrosion inhibitor selected from catechol, gallic acid, lactic acid, benzotriazole and mixtures thereof; and
a bath life extending agent selected from glycerine, propylene glycol and mixtures thereof.

6. The method of Claim 5, wherein the photoresist stripper formulation consists of:
hydroxylamine;
water;
dimethylsulfoxide;
tetramethylammonium hydroxide;
catechol; and,
glycerine.

7. The method of Claim 6, wherein the photoresist stripper formulation consists of:
2.5 to 5 wt % hydroxylamine;
20 to 40 wt % water;
40 to 70 wt % dimethylsulfoxide;
5 to 7.5 wt % tetramethylammonium hydroxide;
0.25 to 1.0 wt % catechol; and
2 to 10 wt% glycerine.

8. The method of Claim 7, wherein the photoresist stripper formulation consists of:
4.13 wt % hydroxylamine;
27 wt % water;
57.18 wt% dimethylsulfoxide;
5.72 wt% tetramethylammonium hydroxide;
0.57 wt % catechol; and
5.4 wt % glycerine.

9. The method of any one of Claims 5 to 8, wherein the photoresist, etch residue or ash residue is contacted with the formulation at a temperature below 70°C.

10. The method of Claim 9, wherein the temperature is 60°C.

11. The method of any one of Claims 5 to 10, wherein the photoresist, etch residue or ash residue is contacted with the formulation for a time of less than 60 minutes.

12. The method of Claim 11, wherein the photoresist, etch residue or ash residue is contacted with the formulation for a time of no more than 30 minutes.

## Patentansprüche

1. Eine Fotolackentfernerformulierung zum Entfernen von Fotolack, Ätzrückstand oder Ascherückstand von der Oberfläche einer Halbleitervorrichtung, wobei die Fotolackentfernerformulierung aus
Hydroxylamin;
Wasser;
einem Lösungsmittel ausgewählt aus Dimethylsulfoxid, N-Methylpyrrolidin, Dimethylacetamid, Dipropylenglycolmonomethylether, Monoethanolamin und Mischungen davon;
einer Base ausgewählt aus Cholin Hydroxid, Monoethanolamin, Tetramethylammonium Hydroxid, Aminoethylethanolamin und Mischungen davon;
einem Metallkorrosionsschutzmittel ausgewählt aus Brenzcatechin, Gallussäure, Milchsäure, Benzotriazol und Mischungen davon; und einem Agens zur Verlängerung der Badstandzeit ausgewählt aus Glycerin, 1,2-Propylenglycol und Mischungen davon,
besteht.

2. Die Formulierung von Anspruch 1, wobei die Fotolackentfernerformulierung aus
Hydroxylamin;
Wasser;
Dimethylsulfoxid;
Tetramethylammonium Hydroxid;
Brenzcatechin; und,
Glycerin,
besteht.

3. Die Formulierung von Anspruch 2, wobei die Fotolackentfernerformulierung aus
2,5 bis 5 Gewichts% Hydroxylamin;
20 bis 40 Gewichts% Wasser;
40 bis 70 Gewichts% Dimethylsulfoxid;
5 bis 7,5 Gewichts% Tetramethylammonium Hydroxid;
0,25 bis 1,0 Gewichts% Brenzcatechin; und
2 bis 10 Gewichts% Glycerin,
besteht.

4. Die Formulierung von Anspruch 3, wobei die Fotolackentfernerformulierung aus
4,13 Gewichts% Hydroxylamin;
27 Gewichts% Wasser;
57,18 Gewichts% Dimethylsulfoxid;
5,72 Gewichts% Tetramethylammonium Hydroxid;
0,57 Gewichts% Brenzcatechin; und
5,4 Gewichts% Glycerin,
besteht.

5. Ein Verfahren zum Entfernen von Fotolack, Ätzrückstand oder Ascherückstand von der Oberfläche einer Halbleitervorrichtung, wobei das Verfahren das in Kontaktbringen des Farblacks, Ätzrückstands oder Ascherückstands mit einer Fotolackentfernerformulierung bestehend aus:
Hydroxylamin;
Wasser;
einem Lösungsmittel ausgewählt aus Dimethylsulfoxid, N-Methylpyrrolidin, Dimethylacetamid, Dipropylenglycolmonomethylether,
Monoethanolamin und Mischungen davon;
einer Base ausgewählt aus Cholin Hydroxid, Monoethanolamin,
Tetramethylammonium Hydroxid, Aminoethylethanolamin und
Mischungen davon;
einem Metallkorrosionsschutzmittel ausgewählt aus Brenzcatechin, Gallussäure, Milchsäure, Benzotriazol und Mischungen davon; und
einem Agens zur Verlängerung der Badstandzeit ausgewählt aus
Glycerin, 1,2-Propylenglycol und Mischungen davon,
umfasst.

6. Das Verfahren von Anspruch 5, wobei die Fotolackentfernerformulierung aus
Hydroxylamin;
Wasser;
Dimethylsulfoxid;
Tetramethylammonium Hydroxid;
Brenzcatechin; und,
Glycerin,
besteht.

7. Das Verfahren von Anspruch 6, wobei die Fotolackentfernerformulierung aus 2,5 bis 5 Gewichts% Hydroxylamin;
20 bis 40 Gewichts% Wasser;
40 bis 70 Gewichts% Dimethylsulfoxid;
5 bis 7,5 Gewichts% Tetramethylammonium Hydroxid;
0,25 bis 1,0 Gewichts% Brenzcatechin; und
2 bis 10 Gewichts% Glycerin,
besteht.

8. Das Verfahren von Anspruch 7, wobei die Fotolackentfernerformulierung aus
4,13 Gewichts% Hydroxylamin;
27 Gewichts% Wasser;
57,18 Gewichts% Dimethylsulfoxid;
5,72 Gewichts% Tetramethylammonium Hydroxid;
0,57 Gewichts% Brenzcatechin; und
5,4 Gewichts% Glycerin,
besteht.

9. Das Verfahren von irgendeinem der Ansprüche 5 bis 8, wobei der Fotolack, Ätzrückstand oder Ascherückstand mit der Formulierung bei einer Temperatur unterhalb 70°C in Kontakt gebracht wird.

10. Das Verfahren von Anspruch 9, wobei die Temperatur 60°C ist.

11. Das Verfahren von irgendeinem der Ansprüche 5 bis 10, wobei der Fotolack, Ätzrückstand oder Ascherückstand mit der Formulierung für einen Zeitraum von weniger als 60 Minuten in Kontakt gebracht wird.

12. Das Verfahren von Anspruch 11, wobei der Fotolack, Ätzrückstand oder Ascherückstand mit der Formulierung für einen Zeitraum von nicht mehr als 30 Minuten in Kontakt gebracht wird.

## Revendications

1. Formulation de dissolvant de résine photosensible destinée à éliminer une résine photosensible, un résidu de gravure ou un résidu de cendres de la surface d'un dispositif semi-conducteur, la formulation de dissolvant de résine photosensible consistant en :
de l'hydroxylamine ;
de l'eau ;
un solvant choisi parmi le diméthylsulfoxyde, la N-méthylpyrrolidine, le diméthylacétamide, le monométhyléther de dipropylène glycol, la monoéthanolamine et des mélanges de ceux-ci ;
une base choisie parmi l'hydroxyde de choline, la monoéthanolamine, l'hydroxyde de tétraméthylammonium, l'aminoéthyléthanolamine et des mélanges de ceux-ci ;
un inhibiteur de corrosion métallique choisi parmi le catéchol, l'acide gallique, l'acide lactique, le benzotriazole et des mélanges de ceux-ci ; et
un agent d'allongement de durée de vie de bain choisi parmi la glycérine, le propylène glycol et des mélanges de ceux-ci.

2. Formulation de la revendication 1, la formulation de dissolvant de résine photosensible consistant en :
hydroxylamine ;
eau ;
diméthylsulfoxyde ;
hydroxyde de tétraméthylammonium ;
catéchol ; et
glycérine.

3. Formulation de la revendication 2, la formulation de dissolvant de résine photosensible consistant en :
2,5 à 5 % en poids d'hydroxylamine ;
20 à 40 % en poids d'eau;
40 à 70 % en poids de diméthylsulfoxyde ;
5 à 7,5 % en poids d'hydroxyde de tétraméthylammonium ;
0,25 à 1,0 % en poids de catéchol ; et
2 à 10 % en poids de glycérine.

4. Formulation de la revendication 3, la formulation de dissolvant de résine photosensible consistant en :
4,13 % en poids d'hydroxylamine ;
27 % en poids d'eau ;
57,18 % en poids de diméthylsulfoxyde ;
5,72 % en poids d'hydroxyde de tétraméthylammonium ;
0,57 % en poids de catéchol ; et
5,4 % en poids de glycérine.

5. Procédé d'élimination d'une résine photosensible, d'un résidu de gravure ou d'un résidu de cendres de la surface d'un dispositif semi-conducteur, le procédé comprenant la mise en contact de la résine photosensible, du résidu de gravure ou du résidu de cendres avec une formulation de dissolvant de résine photosensible consistant en :
de l'hydroxylamine ;
de l'eau ;
un solvant choisi parmi le diméthylsulfoxyde, la N-méthylpyrrolidine, le diméthylacétamide, le monométhyléther de dipropylène glycol, la monoéthanolamine et des mélanges de ceux-ci ;
une base choisie parmi l'hydroxyde de choline, la monoéthanolamine, l'hydroxyde de tétraméthylammonium, l'aminoéthyléthanolamine et des mélanges de ceux-ci ;
un inhibiteur de corrosion métallique choisi parmi le catéchol, l'acide gallique, l'acide lactique, le benzotriazole et des mélanges de ceux-ci ; et
un agent d'allongement de durée de vie de bain choisi parmi la glycérine, le propylène glycol et des mélanges de ceux-ci.

6. Procédé de la revendication 5, dans lequel la formulation de dissolvant de résine photosensible consiste en :
hydroxylamine ;
eau ;
diméthylsulfoxyde ;
hydroxyde de tétraméthylammonium ;
catéchol ; et
glycérine.

7. Procédé de la revendication 6, dans lequel la formulation de dissolvant de résine photosensible consiste en :
2,5 à 5 % en poids d'hydroxylamine ;
20 à 40 % en poids d'eau ;
40 à 70 % en poids de diméthylsulfoxyde ;
5 à 7,5 % en poids d'hydroxyde de tétraméthylammonium ;
0,25 à 1,0 % en poids de catéchol ; et
2 à 10 % en poids de glycérine.

8. Procédé de la revendication 7, dans lequel la formulation de dissolvant de résine photosensible consiste en :
4,13 % en poids d'hydroxylamine ;
27 % en poids d'eau ;
57,18 % en poids de diméthylsulfoxyde ;
5,72 % en poids d'hydroxyde de tétraméthylammonium ;
0,57 % en poids de catéchol ; et
5,4 % en poids de glycérine.

9. Procédé selon l'une quelconque des revendications 5 à 8, dans lequel la résine photosensible, le résidu de gravure ou le résidu de cendres est mis en contact avec la formulation à une température inférieure à 70 °C.

10. Procédé de la revendication 9, dans lequel la température est 60 °C.

11. Procédé selon l'une quelconque des revendications 5 à 10, dans lequel la résine photosensible, le résidu de gravure ou le résidu de cendres est mis en contact avec la formulation pendant une durée inférieure à 60 minutes.

12. Procédé de la revendication 11, dans lequel la résine photosensible, le résidu de gravure ou le résidu de cendres est mis en contact avec la formulation pendant une durée qui n'est pas supérieure à 30 minutes.
